# EUROPEAN PATENT APPLICATION

(11) **EP 1 394 936 A2**
(43) Date of publication of application: **03.03.2004**
(21) Application number: 03077388.1
(22) Date of filing: 30.07.2003
(51) Int. Cl.: H03G 3/20, H03G 3/30

(54) **Enhanced automatic gain control**

(30) Priority: 27.08.2002 US 229842
(71) Applicant: Delphi Technologies, Inc., Troy, MI 48007 (US)
(72) Inventor: Marrah, Jeffrey J., Kokomo, IN 46901 (US); Brandenburg, Todd M., Kokomo, IN 46902 (US); Pervez, Rohail A., Kokomo, IN 46902 (US)
(74) Representative: Denton, Michael John

(57) **Abstract**

An automatic gain control circuit (10) that maximizes front-end signal attenuation is disclosed. The automatic gain control circuit (10) comprises a keyed automatic gain control circuit (50) and an intermodulation detector (12). The intermodulation detector (12) detects signal interference and generates an intermodulation detection flag (19). The keyed automatic gain control circuit (50) uses the intermodulation detection flag (19) to control front-end signal attenuation. A method for maximizing front-end signal attenuation for the automatic gain control circuit (10) is also disclosed.

## Description

### Technical Field

The present invention relates to automatic gain control circuits. More specifically, the present invention relates to an automatic gain control circuit that maximizes front-end signal attenuation.

### Background of the Invention

A majority of receiver designs employ some form of front-end automatic gain control (AGC) to limit the amount of signal power present at the mixer input. This limits the signal being presented to the mixer and maintains a higher dynamic range. Three often-used terms in receiver front-end AGC circuits are "wideband AGC" (WBAGC), "narrowband AGC" (NBAGC), and "keyed AGC" (KAGC). WBAGC refers to the wide bandwidth signal strength indication of the total FM band. NBAGC refers to the on-channel bandwidth signal strength indication of a desired signal as defined by the bandwidth of the intermediate frequency (IF) strip. KAGC refers to a design that utilizes a control algorithm that limits the front-end attenuation based on the level of the desired signal.

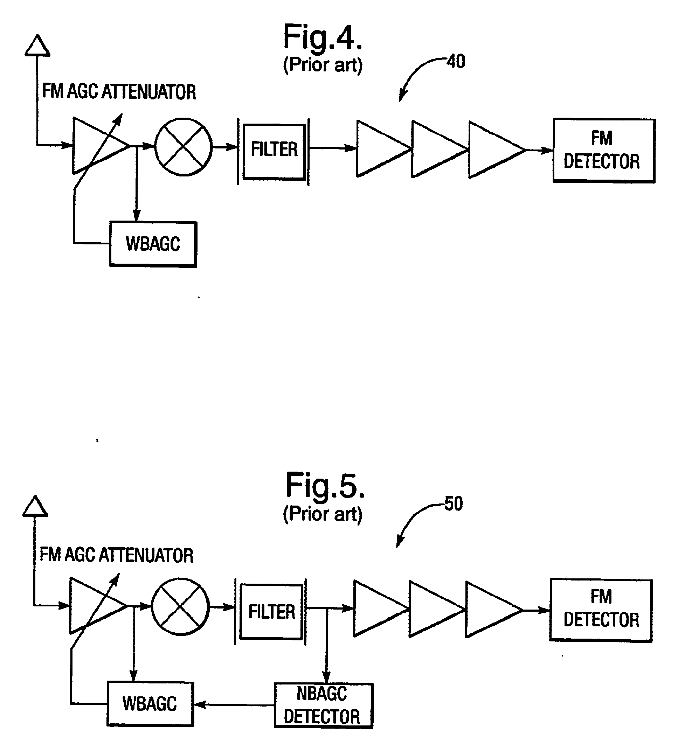

Referring to the block diagram in Figure 4, the conventional implementation of AGC has been to use a WBAGC circuit 40 as a control mechanism for front-end signal attenuation. Modification to the WBAGC circuit 40 has been to use the NBAGC to limit the amount of WBAGC that can be applied to the front-end for signal attenuation. Referring to the block diagram in Figure 5, this modification is most commonly called the KAGC circuit 50.

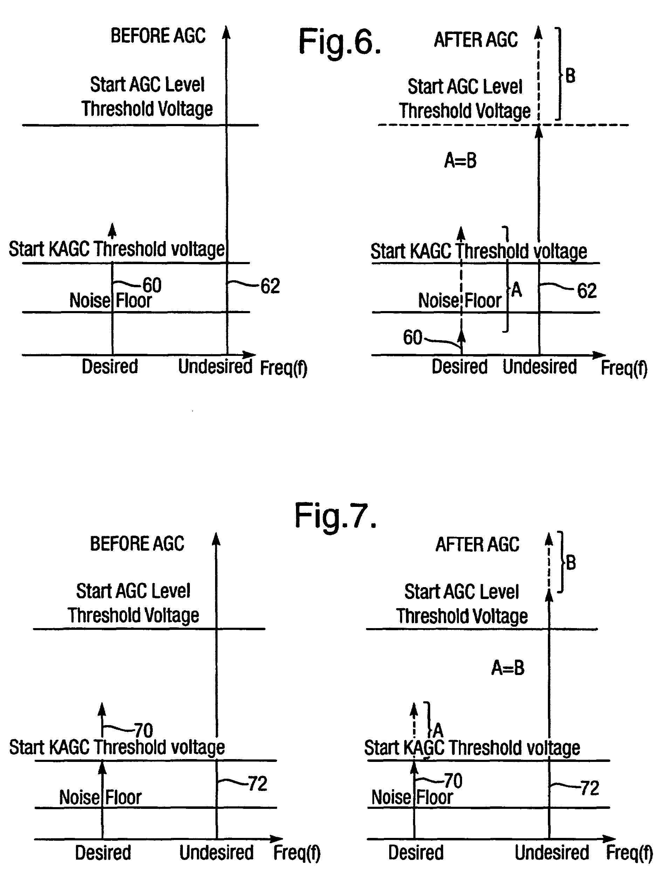

In such AGC circuits 40, 50, a situation is often present where there is a desired signal 60 that is weak and an undesired signal 62 (i.e. an undesired interferer) that is strong (Figures 6, 7). In the conventional WBAGC circuit 40, the amount of the front-end attenuation (i.e. attenuation magnitude A, B) is dictated entirely by the RF strength of the undesired signal 62. The attenuation magnitude, A, of the desired signal 60 is typically approximately equivalent to the attenuation magnitude, B, of the undesired signal 62. Referring to Figure 6, the WBAGC circuit 40 can essentially attenuate the desired signal 60 below any listenable level (i.e. a noise floor) by the attenuation magnitude, A, after the AGC is applied. When the attenuation of the desired signal 60 is below any listenable level, the situation is commonly referred to as desensitization or "flushing." Thus, without KAGC, the desired signal 60 is flushed.

The KAGC circuit 50 works satisfactorily for conditions in which the undesired signals do not produce intermodulation (IM) products that fall on the desired signal. Referring to Figure 7, the KAGC circuit 50 prevents the desired signal 70 from being flushed for such conditions and is above the noise floor. Hence, the KAGC circuit 50 reduces the amount of desensitization of the desired signal 70. Similar to the WBAGC circuit 40 for Figure 6, the attenuation magnitude, A, of the desired signal 70 is typically approximately equivalent to the attenuation magnitude, B, of the undesired signal 72 in the KAGC circuit 50.

The amount of attenuation magnitude A, B in the KAGC circuit 50 is limited by the strength of the weak signal station. The limit to which this attenuation is applied is set with an internal reference in the front end IC (i.e. RFIC). This reference is compared with the narrowband level voltage or received signal strength indicator (RSSI). Once this narrowband level voltage reaches the threshold value of the comparator, no further attenuation is applied. The amount of the front-end AGC is limited with the help of the narrowband IF signal.

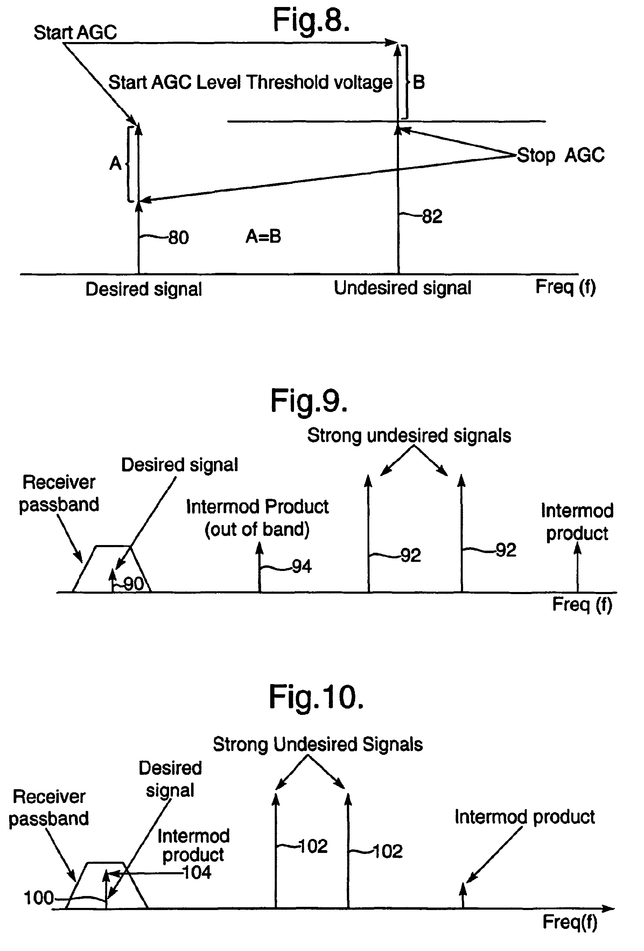

Three different signal condition situations, which occur without producing any intermodulation (IM) products at the desired signal frequency, are covered with the present conventional systems that employ a combination of both the conventional WBAGC circuit 40 and the KAGC circuit 50. In a first situation (not shown), when the desired and undesired signals are both weak, no attenuation is applied in an AGC action for the WBAGC circuit 40. In a second situation for the WBAGC circuit 40 as seen in Figure 8, when the desired signal 80 and the undesired signal 82 are strong, the desired AGC action is to apply attenuation until the undesired signal 82 reaches the threshold level. Thus, the desired signal 80 is attenuated down in magnitude that is approximately equivalent to A, and the undesired signal is attenuated down in magnitude that is approximately equivalent to B, where A is equal to B. In a third situation for the KAGC circuit 50 as seen in Figure 9, when the desired signal 90 is weak and more than one strong undesired signal 92 produces an out-of-band IM product 94, the desired AGC action is to apply AGC until the desired signal 90 is desensitized to the KAGC level.

However, the deficiency as seen in Figure 10, when two strong undesired signals 102 produce an inband IM product 104, the deficiency of the third situation is the KAGC's inability to decipher between the desired signal 100 and the IM product 104 that occupies the same bandwidth as the desired signal 100. These types of IM products 104 are one subset of generalized FM undesired spurious responses. These responses are generated by non-linear mixing operations that include harmonics of an IF signal, the local oscillator signal, and signals at the receiver input.

It is contemplated by the applicants that conventional AGC circuits 40, 50 may be enhanced to detect a spurious response at the desired frequency. Therefore, it is an objective of the applicants to overcome the fallbacks of conventional AGC circuits 40, 50 to allow the front-end to exert full attenuation of the incoming signals without being limited by conventional AGC circuits 40, 50.

### Summary of the Invention

Accordingly one embodiment of the present invention is directed to an automatic gain control circuit that maximizes front-end signal attenuation. The automatic gain control circuit comprises an intermodulation detector and a keyed automatic gain control circuit. The intermodulation detector detects front-end signal interference and generates an intermodulation detection flag. The keyed automatic gain control circuit uses the intermodulation detection flag to control the front-end signal attenuation.

Another embodiment of the invention comprises means for detecting signal interference, means for generating an intermodulation detection flag, and means for controlling the keyed automatic gain control circuit.

Another embodiment of the invention is directed to a method for maximizing front-end signal attenuation for an automatic gain control circuit. The automatic gain control circuit comprises a keyed automatic gain control circuit and an intermodulation detector. The method comprises the steps of receiving a desired signal and an undesired signal, producing signal interference, detecting the signal interference, generating a detection flag, deactivating the keyed automatic gain control circuit. and flushing the undesired signal.

### Brief Description of the Drawings

Figure 1 is a block diagram of an enhanced automatic gain control (AGC) system according to the present invention;
Figure 2 is a representative view of a signal condition when an inband intermodulation (IM) product is produced by two signals;
Figure 3 is a representative view of a signal condition including a weak desired signal and a strong undesired signal when no inband IM products are generated;
Figure 4 is a block diagram of a conventional wideband AGC (WBAGC) circuit;
Figure 5 is a block diagram of a conventional keyed AGC (KAGC) circuit;
Figure 6 is a representative view when a desired signal is flushed in the WBAGC circuit of Figure 4;
Figure 7 is a representative view when the KAGC circuit of Figure 5 prevents the desired signal from being flushed;
Figure 8 is a representative view of a signal condition showing an AGC application for the WBAGC circuit of Figure 4;
Figure 9 is a representative view of a signal condition showing an AGC application for the KAGC circuit of Figure 5 that generates an out-of-band intermodulation product; and
Figure 10 is a representative view of a signal condition showing an AGC application for the KAGC circuit of Figure 5 that generates an inband intermodulation product.

### Detailed Description of the Preferred Embodiments

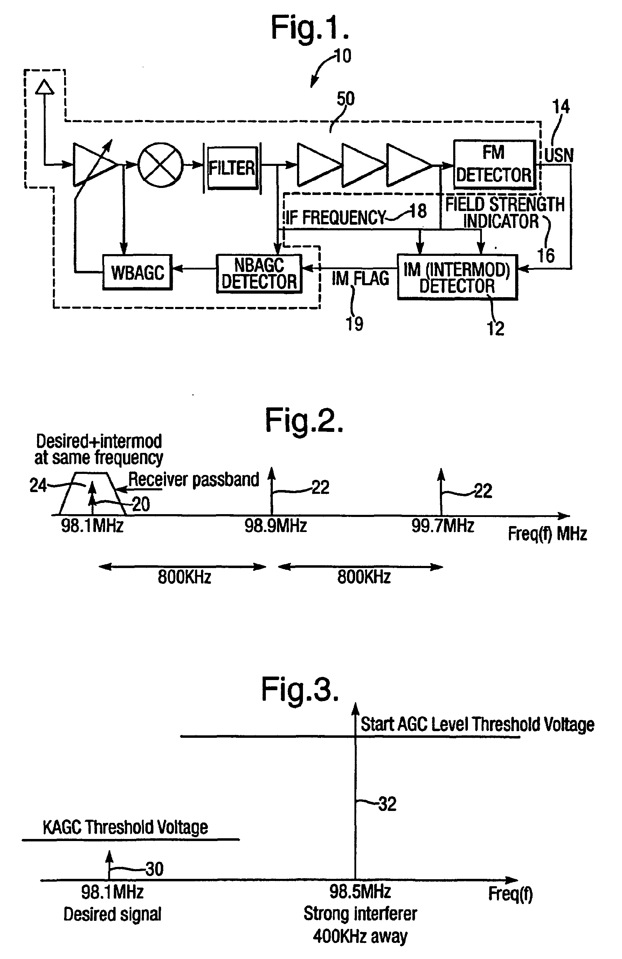

The AGC system, which is shown generally at 10 in Figure 1, enhances the capabilities of the conventional KAGC circuit 50 by detecting a spurious response at a desired frequency. Once this is accomplished, it will allow the front-end to exert full attenuation on the incoming signals by essentially turning the KAGC function off without being limited by the KAGC function. In the following description of the preferred embodiment, it is assumed that the WBAGC and the KAGC are fully turned on.

The detection of signal interference can be accomplished as follows: a typical FM detector (i.e. an FM demodulator) is a circuit whose output voltage is proportional to the difference between a reference frequency and the frequency of an input signal. Hence, large frequency excursions or deviations of the input signal produces large voltage swings at the output. One source of large frequency variations beyond the standard FM deviations is the direct result of IM products being present on the desired signal (Figure 10). Fast voltage swings at the output generate broad frequency spectrums that are used to generate ultra sonic noise 14 (USN). In the AGC system 10, means for detecting front- end signal interference, such as an IM detector 12, detects the USN 14. Means for generating, such as the IM detector 12, generates an intermodulation (IM) detection flag 19. Means for controlling the KAGC circuit 50, such as the IM detection flag 19, is used as a control signal for controlling the KAGC action (i.e. turning off the KAGC function) at the front-end of the receiver.

Because there are several other conditions that can result in USN activity, this particular IM detection flag 19 alone that is generated by the IM detector 12 in the presence of USN 14 is not sufficient to reliably predict the IM product presence. It should be noted however, that the USN activity that is generated as a result of the IM situation is appreciably higher than any other scenario that may result in USN activity. This is readily observed from the fact that IM products are typically generated with higher order harmonics. A higher order harmonic will imply that the frequency deviations of the FM signals are also being amplified with the order of the harmonics involved. Hence, this will typically give rise to a higher quantitative amount of USN 14.

To further limit the probability of a false trigger of the KAGC system, a level signal or field strength signal indicator 16 can also be used as an input for the IM detector 12 in order to generate the IM detection flag 19. The field strength indicator 16 is used to set the KAGC threshold and is located at the output of the long amplifier in the KAGC circuit 50. With this vital information available, it can be readily determined when the desired signal has reached a low RF level at the point of the AGC set threshold. This information, coupled with the knowledge that the WBAGC is active, can provide one of the triggers for turning off the KAGC function.

Another source of signal interference that can also be used in order to generate the IM detection flag 19 is the AM wideband (AMWB) signal. As the name would indicate, AMWB is the measure of AM that is created on a FM signal due to the presence of multipath interference. The field strength indicator 16 may be sent to an AMWB detector (not shown) when the desired signal is rapidly changing. Hence, the field strength indicator 16 attempts to track the AMWB signal, which results in a full-wave rectified AM signal that is proportional to the amount of amplitude of the desired signal. The AMWB detector generates a DC voltage that is projected off of the AMWB signal from the field strength indicator 16. The AMWB detector essentially detects the DC average of the field strength indicator 16, which in turn provides an amount of variation in the desired signal. Although the AMWB detector is not shown, it may be similarly located where the IM detector 12 is shown in Figure 1.

AMWB is commonly used in the receiver design to detect the presence of multipath interference in the FM signal transmission. It would appear that in the presence of an IM signal, there would be less multipath interference generated. In an IM situation, it is already established that the desired signal is very weak. Thus, the amount of AM on this signal is also less when compared to a relatively high desired signal. Hence, a lesser amount of AMWB indication can also be used as an IM detection flag 19 in controlling the KAGC function.

Another source of signal interference that can also be used in order to generate the IM detection flag 19 in the AGC system 10 is the IF frequency 18 itself. Over-modulations of the IF that effect the IM signals can also be detected at the IF.

For the AGC system 10 described above, there are two situations that produce IM products that are at the frequency of the desired channel. In a first situation as seen in Figure 2, when the desired signal 20 (shown at 98.1 MHz) is weak and the undesired signals 22 are strong (shown at 98.9 MHz and 99.7 MHz), an inband IM product 24 is generated and the IM detector 12 is triggered (i.e. FM(IM) = 2F₁-F₂; FM(IM) = 2*98.9-99.7 = 98.1). When the IM product 24 is generated, the audio level of the IM product 24 will be twice of what it's being broadcast. Thus, the KAGC function does not turn on, and the AGC system 10 applies attenuation to eliminate the undesirable signal 22 by applying enough AGC to bring the undesired signal to the start of AGC because the IM product 24 is competing with the desired signal 20.

In a second situation as seen in Figure 3, when the desired signal 30 (shown at 98.1 MHz) is very weak (i.e. the S/N is below a listenable level) and the undesired signal 32 (shown at 98.5 MHz) is strong, no inband IM products are generated. Thus, the KAGC does not turn on, and the AGC system 10 applies attenuation to flush the undesirable signal 32.

This approach may desensitize the desired signal 30. However, the desensitization of the desired signal 30 does not have a major importance in the AGC system 10 if it is below a listenable level. If this did happen, the output of the receiver would be static (i.e. no signal present). From a user's standpoint, it would be preferable to listen to static than the IM product.

As shown above, the AGC system 10 uses the detection flags 14, 16, and 18 to help determine the presence of IM products, and when present, allow the KAGC function to switch off with controlling means, such as a control signal 19, so that the undesirable signal may become flushed. While maintaining the implementation of the KAGG circuit 50 when no inband IM products are present, the AGC system 10 employs the advantage of turning the KAGC function off when inband IM products are generated. Thus, the front-end of the receiver exerts maximum attenuation in order to minimize the effects of the undesired signal. The KAGC function also turns off when a desired signal that is below the KAGC threshold level is very weak and when a strong undesired signal that turns the WBAGC on is present. Thus, the result is a limited amount of front-end attenuation because there is little or no KAGC signal present to control the amount of the attenuation. If the KAGC is turned off completely, the front-end will fully attenuate the undesired signal. Thus, when the KAGC is completely turned off, it does not matter if the desired signal is attenuated with the undesired signal because it had poor listening quality to begin with.

It should be understood that various alternatives to the embodiments of the invention described herein may be employed in practicing the invention. It is intended that the following claims define the scope of the invention and that the method and apparatus within the scope of these claims and their equivalents be covered thereby.

## Claims

1. An automatic gain control circuit (10) that maximizes front-end signal attenuation, comprising:
an intermodulation detector (12) that detects front-end signal interference and generates an intermodulation detection flag (19); and
a keyed automatic gain control circuit (50) that uses the intermodulation detection flag (19) to control the front-end signal attenuation.

2. The automatic gain control circuit (10) of claim 1, wherein the front-end signal interference is detected from ultrasonic noise (14).

3. The automatic gain control circuit (10) of claim 1, wherein the front-end signal interference is detected from a field strength signal indicator (16).

4. The automatic gain control circuit (10) of claim 1, wherein the front-end signal interference is detected from an AM wideband signal.

5. The automatic gain control circuit (10) of claim 1, wherein the front-end signal interference is detected from an intermediate frequency (18).

6. An automatic gain control circuit (10) that maximizes front-end signal attenuation, the automatic gain control circuit (10) comprising a keyed automatic gain control circuit (50) and an intermodulation detector (12), comprising:
means for detecting signal interference;
means for generating an intermodulation detection flag (19); and
means for controlling the keyed automatic gain control circuit (50).

7. The automatic gain control circuit (10) of claim 6, wherein means for detecting signal interference comprises an intermodulation detector (12).

8. The automatic gain control circuit (10) of claim 7, wherein means for generating an intermodulation detection flag (19) comprises the intermodulation detector (12).

9. The automatic gain control circuit (10) of claim 6, wherein means for controlling the keyed automatic gain control circuit (50) is the intermodulation detection flag (19).

10. A method for maximizing front-end signal attenuation for an automatic gain control circuit (10), the automatic gain control circuit (10) comprises a keyed automatic gain control circuit (50) and an intermodulation detector (12), comprising the steps of:
receiving a desired signal (20, 30) and an undesired signal (22, 32);
producing signal interference;
detecting the signal interference;
generating a detection flag (19);
deactivating the keyed automatic gain control circuit (50); and
flushing the undesired signal (22, 32).

11. The method according to claim 10 further comprising the step of flushing the desired signal (20, 30).

12. The method according to claim 10, wherein the detecting step is carried out by an intermodulation detector (12).

13. The method according to claim 12, wherein the generating step is carried out by the intermodulation detector (12).

14. The method according to claim 10, wherein the deactivating step is carried out by the detection flag (19).

15. The method according to claim 10, wherein the signal interference is an intermodulation product (24).
